# EUROPÄISCHE PATENTANMELDUNG

(11) **EP 1 031 986 A2**
(43) Veröffentlichungstag der Anmeldung: **30.08.2000**
(21) Anmeldenummer: 00103878.5
(22) Anmeldetag: 24.02.2000
(51) Int. Cl.: G11C 7/06

(54) **Leseverstärkeranordnung mit verschmolzenen Diffusionsgebieten und verteiltem Treibersystem**

(30) Priorität: 24.02.1999 DE 19907922
(71) Anmelder: Infineon Technologies AG, 81541 München (DE)
(72) Erfinder: Chrysostomides, Athanasia, 81929 München (DE); Savignac, Dominique, Dr., 85737 Ismaning (DE); Feurle, Robert, 85579 Neubiberg (DE); Schneider, Helmut, 80993 München (DE)
(74) Vertreter: Zedlitz, Peter, Dipl.-Ing.

(57) **Zusammenfassung**

Die Erfindung betrifft eine Leseverstärkeranordnung, bei der Sense-Amp-Transistoren (6) in einem gemeinsamen durchgehenden Diffusionsgebiet (8) neben Treibern (5) angeordnet sind, so daß eine kurze lokale Verbindung (7) zwischen den Sense-Amp-Transistoren (6) und den Treibern (5) gewährleistet ist.

## Beschreibung

Die vorliegende Erfindung betrifft eine Leseverstärkeranordnung für eine Halbleiterspeichervorrichtung mit einer Vielzahl von Leseverstärker-(Sense-Amp-)Transistoren und diesen zugeordneten Treibern. Solche Leseverstärker werden häufig auch als Schreib-Leseverstärker bezeichnet.

Unter "Treibern" soll im folgenden ein einziger Transistor oder auch eine Vielzahl von Einzeltransistoren verstanden werden, die jeweils zur Ansteuerung der Sense-Amp-Transistoren vorgesehen sind.

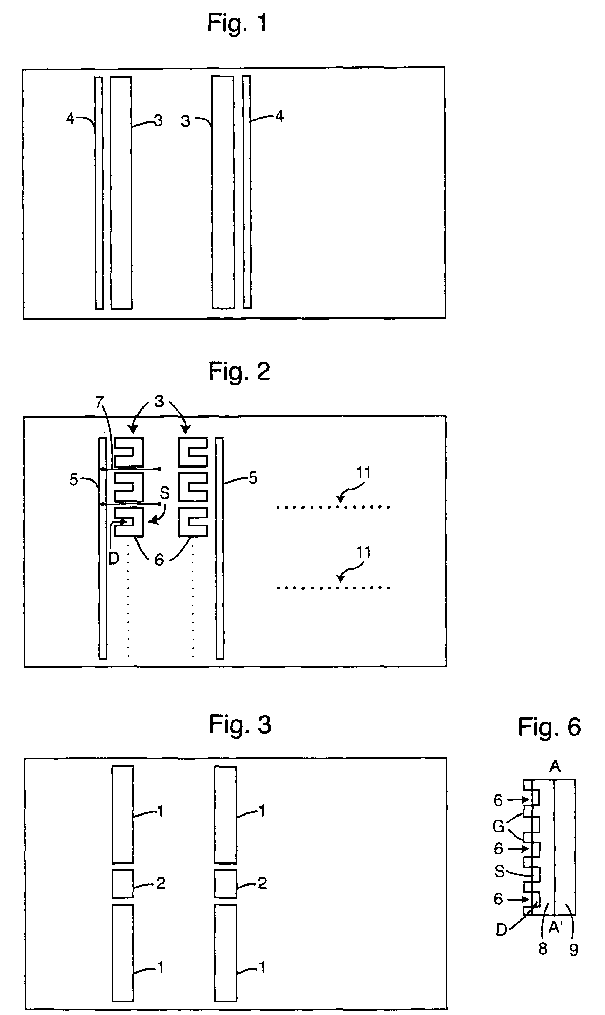

Bei bestehenden Halbleiterspeichervorrichtungen sind die Sense-Amp-Transistoren abwechselnd mit Treibern am Rand eines Zellenfeldes angeordnet. Das heißt, auf eine Gruppe von Sense-Amp-Transistoren folgt ein Treiber, woran sich wieder eine Gruppe von Sense-Amp-Transistoren anschließt. Eine derartige Anordnung ist in Fig. 3 gezeigt, in welcher Gruppen 1 von Sense-Amp-Transistoren abwechselnd mit Treibern 2 dargestellt sind, wobei sich bei dieser Anordnung das Zellenfeld beispielsweise auf der rechten Seite von Fig. 3 befindet.

Eine derartige Gestaltung von Sense-Amp-Transistoren 1 und Treibern 2 eröffnet für das Layout von Halbleiterspeichervorrichtungen bestimmte Vorteile, weshalb bisher von einer solchen Ausführung nicht abgegangen wurde. Diese Vorteile liegen beispielsweise in einer Flächeneinsparung infolge der abwechselnden Ausführung von Sense-Amplifier-Gruppen und Treibern.

Nachteilhaft an der bestehenden Leseverstärkeranordnung gemäß Fig. 3 ist aber, daß die einzelnen Sense-Amp-Transistor-Gruppen 1 jeweils verschiedene Diffusionsgebiete haben und außerdem die Verdrahtungsstrecken zwischen einzelnen Sense-Amp-Transistoren der jeweiligen Gruppen 1 und dem zugehörigen Treiber 2 relativ lang sein können.

Es ist daher Aufgabe der vorliegenden Erfindung, eine Leseverstärkeranordnung zu schaffen, bei der kritische Diffusionsgebietsabstände zwischen einzelnen Sense-Amp-Transistor-Gruppen vermieden werden und bei der eine optimale Ankopplung der Treiber zu den Sense-Amp-Transistoren erzielbar ist.

Diese Aufgabe wird bei einer Leseverstärkeranordnung der eingangs genannten Art erfindungsgemäß dadurch gelöst, daß die Sense-Amp-Transistoren jedes Leitungstyps jeweils ein gemeinsames durchgezogenes Diffusionsgebiet aufweisen und die Treiber für die Sense-Amp-Transistoren parallel zu dem Diffusionsgebiet unmittelbar neben diesem angeordnet sind.

Bei der erfindungsgemäßen Leseverstärkeranordnung wird also das Konzept des bisherigen Layouts für die Leseverstärker und Treiber verlassen: anstelle der abwechselnden Anordnungen von Sense-Amp-Transistor-Gruppen und Treibern sind hier zunächst für die Sense-Amp-Transistoren jedes Leitungstyps, also für P-Sense-Amp-Transistoren und N-Sense-Amp-Transistoren, jeweils ein streifenförmiges durchgehendes Diffusionsgebiet vorgesehen, so daß für die Fertigung kritische Diffusionsgebietsabstände grundsätzlich vermieden werden. Die Treiber liegen jeweils direkt neben den N-Sense-Amp-Transistoren bzw. den P-Sense-Amp-Transistoren, so daß eine optimale Ankopplung zwischen den Treibern und den Sense-Amp-Transistoren erfolgen kann und insbesondere keine großen Verdrahtungswiderstände die Ladungsübertragung verzögern.

Wesentlich an der vorliegenden Erfindung ist also, daß jeweils alle P-Sense-Amp-Transistoren und alle N-Sense-Amp-Transistoren ein gemeinsames Diffusionsgebiet haben, das an der Seite eines Speicherzellenfeldes gelegen ist. Parallel zu diesen Diffusionsgebieten für die P-Sense-Amp-Transistoren bzw. die N-Sense-Amp-Transistoren ist jeweils ein Treiber aus einem oder einer Vielzahl von Transistoren, wie eingangs erläutert wurde, vorgesehen.

Eine Weiterbildung der Erfindung besteht darin, daß die Sense-Amp-Transistoren U-förmig gestaltet und linear in einer Reihe angeordnet sind, so daß sich die Schenkel des "U" in jeweils einer Reihe in die gleiche Richtung erstrecken, und daß die Treiber parallel zu der Reihe längs den offenen Schenkeln angeordnet sind.

Durch die U-förmige Gestaltung der Sense-Amp-Transistoren wird deren Weite praktisch verdoppelt. Anstelle der bisher gerade verlaufenden Gates der Sense-Amp-Transistoren der bestehenden Halbleiterspeichervorrichtungen werden bei der erfindungsgemäßen Leseverstärkeranordnung also Sense-Amp-Transistoren eingesetzt, deren Gates nicht mehr gerade, sondern U-förmig sind, was die Kanalweite in vorteilhafter Weise im wesentlichen verdoppelt.

Diese U-förmigen Sense-Amp-Transistoren sind, worauf bereits hingewiesen wurde, jeweils in unmittelbarer Nähe zu den Treibern vorgesehen, so daß zwischen den Treibern und den Sense-Amp-Transistoren kurze lokale Verbindungen ohne große Verdrahtungswiderstände aufgebaut werden können. Verzögerungen in der Leistungsübertragung zwischen den Treibern und den Sense-Amp-Transistoren werden dadurch vermieden.

Es ist auch noch vorteilhaft, daß sich bei den U-förmigen Sense-Amp-Transistoren Drain zwischen den Schenkeln des "U" und Source außerhalb der Schenkel des "U" befinden.

Nachfolgend wird die Erfindung anhand der Zeichnungen näher erläutert. Es zeigen:
- Fig. 1: eine schematische Draufsicht der erfindungsgemäßen Leseverstärkeranordnung,
- Fig. 2: eine Draufsicht der Leseverstärkeranordnung von Fig. 1 mit der Gestaltung der einzelnen Sense-Amp-Transistoren,
- Fig. 3: eine Draufsicht auf eine bestehende Leseverstärkeranordnung,
- Fig. 4: eine Draufsicht auf eine Diffusionsebene der erfindungsgemäßen Leseverstärkeranordnung,
- Fig. 5: eine Draufsicht auf eine höher gelegene Verdrahtungsebene der Leseverstärkeranordnung von Fig. 4 und
- Fig. 6: einen Schnitt AA' in Fig. 4.

Fig. 3 ist bereits eingangs erläutert worden.

Fig. 1 zeigt eine schematische Draufsicht auf die erfindungsgemäße Leseverstärkeranordnung. Bei dieser sind Streifen 3 von Sense-Amp-Transistoren neben einem Speicherzellenfeld (in Fig. 1 beispielsweise auf der rechten Seite) vorgesehen. Direkt neben jedem Streifen 3 ist ein Treiber 4 vorgesehen, so daß zwischen den einzelnen Sense-Amp-Transistoren des Streifens 3 und dem Treiber 4 kurze Verdrahtungen bestehen.

Fig. 2 zeigt die Streifen 3 in Einzelheiten: jeder Streifen 3 besteht aus einer Reihe von U-förmigen MOS-Sense-Amp-Transistoren 6, wobei das dargestellte "U" die Gestalt der Gateelektrode wiedergibt. Zwischen den Schenkeln des "U" befindet sich Drain D, während Source S auf der Außenseite des "U" angeordnet ist. Durch diese Gestaltung der Sense-Amp-Transistoren 6 ergibt sich eine große Kanalweite, was für die Sense-Amp-Transistoren und deren Funktion vorteilhaft ist.

Diese Sense-Amp-Transistoren 6 liegen alle in einem gemeinsamen Diffusionsgebiet, das für beide Streifen 3 gemeinsam ist. Dieses Diffusionsgebiet kann N-leitend oder P-leitend sein, was davon abhängt, ob die Sense-Amp-Transistoren 6 N-Kanal-MOS-Transistoren oder P-Kanal-MOS-Transistoren sind. Für N-Kanal-MOS-Transistoren kann beispielsweise ein P-leitendes Diffusionsgebiet verwendet werden, während für P-Kanal-MOS-Transistoren ein N-leitendes Kanalgebiet angewandt wird.

Sind bei einer Halbleiterspeicheranordnung N-Sense-Amp-Transistoren und P-Sense-Amp-Transistoren vorgesehen, so wird die Anordnung von Fig. 2 wiederholt, was durch Punkte 11 angedeutet ist. Das heißt, wenn in Fig. 2 beispielsweise N-Sense-Amp-Transistoren 6 gezeigt sind, so wird die gleiche Anordnung mit Reihen 3 und Treibern 5 für P-Sense-Amp-Transistoren wiederholt, wie dies durch die Punkte 11 angegeben ist.

Die Treiber 5 liegen nahe bei den Sense-Amp-Transistoren 6, so daß durch Verdrahtungen 7 mittels kurzer lokaler Verbindungen die gewünschten Elektroden (Source-Knoten) der Sense-Amp-Transistoren 6 mit den Treibern 5 verbunden werden können. Da die Verdrahtungswiderstände dadurch niedrig sind, wird eine Verzögerung der Leistungsübertragung vermieden.

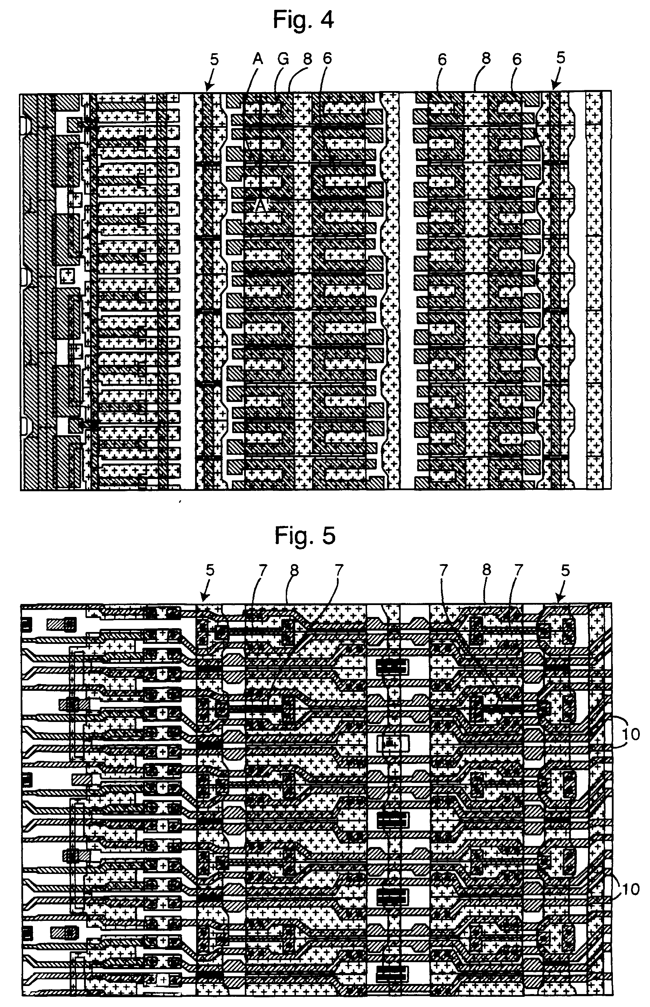

Fig. 4 zeigt eine Draufsicht auf eine Ebene oberhalb der Diffusionsbereiche mit zweimal zwei Streifen von Sense-Amp-Transistoren 6 (zur Verdeutlichung ist einer dieser Sense-Amp-Transistoren 6 mit seinen Kontakten hervorgehoben dargestellt). Neben diesen Streifen 3 sind die Treiber 5 zu sehen, wobei hier beiden Streifen 3 nur ein Treiber 5 zugeordnet ist. Gegebenenfalls kann aber auch ein zweiter Treiber 5 vorgesehen werden, wie dies in Fig. 2 schematisch gezeigt ist.

Die in Fig. 4 links gezeigten Streifen 3 bilden N-Sense-Amp-Transistoren, während die in Fig. 4 rechts dargestellten Streifen 3 P-Sense-Amp-Transistoren enthalten. Wie aus der Fig. 4 zu ersehen ist, liegen die Treiber 5 aus einem oder mehreren Transistoren in unmittelbarer Nähe zu den Sense-Amp-Transistoren 6, so daß durch die Verdrahtungen 7 ein niedriger Verdrahtungswiderstand und eine praktisch verzögerungsfreie Leistungsübertragung gewährleistet werden kann.

Die Sense-Amp-Transistoren 6 befinden sich in einem Diffusionsgebiet 8, das im vorliegenden Beispiel der Fig. 4 und 5 für jeweils zwei Streifen 3 der Sense-Amp-Transistoren 6 gemeinsam ist.

Fig. 6 zeigt einen Schnitt AA' durch drei Sense-Amp-Transistoren 6 in einem Diffusionsgebiet 8 auf einem Halbleitersubstrat 9. Gateelektroden G sind U-förmig, Source S ist außerhalb des "U" angeordnet, während Drain D innerhalb des "U" liegt.

Fig. 5 ist eine weitere Draufsicht in einer Metallisierungsebene, die oberhalb der Ebene von Fig. 4 liegt. Aus dieser Figur sind insbesondere die Verdrahtungen 7 zur Verbindung zwischen den Sense-Amp-Transistoren 6 und den Treibern 5 zu ersehen. Außerdem sind noch Bitleitungen 10 gezeigt, die in einer höheren Ebene über den Sense-Amp-Transistoren 3 und den Treibern 5 verlaufen.

Vorteilhaft an der erfindungsgemäßen Leseverstärkeranordnung ist insbesondere die optimale Ankopplung der Sense-Amp-Transistoren 3 an die Treiber 5 ohne große Verdrahtungswiderstände und die vollständig verschmolzene Gestaltung der Diffusionsgebiete 8 der Sense-Amp-Transistoren 3.

## Patentansprüche

1. Leseverstärkeranordnung für Halbleiterspeichervorrichtung mit einer Vielzahl von Leseverstärker-(Sense-Amp-)Transistoren (6) und diesen zugeordneten Treibern (5),
**dadurch gekennzeichnet,** daß
die Leseverstärker-Transistoren (6) jedes Leitungstyps jeweils ein gemeinsames durchgezogenes Diffusionsgebiet (8) aufweisen und die Treiber (5) für die Leseverstärker-Transistoren (6) parallel zu dem Diffusionsgebiet (8) unmittelbar neben diesen angeordnet sind.

2. Leseverstärkeranordnung nach Anspruch 1,
**dadurch gekennzeichnet,** daß
die Leseverstärker-Transistoren (6) U-förmig gestaltet und linear in Reihen (3) angeordnet sind, so daß sich die Schenkel des "U" in jeweils einer Reihe in einer Richtung erstrecken und der Treiber (5) parallel zu der Reihe (3) längs den offenen Schenkeln angeordnet ist.

3. Leseverstärkeranordnung nach Anspruch 1 oder 2,
**dadurch gekennzeichnet,** daß
zwischen jedem Leseverstärker-Transistor (6) und dem Treiber (5) eine kurze lokale Verbindung (7) besteht.

4. Leseverstärkeranordnung nach Anspruch 2 oder 3,
**dadurch gekennzeichnet,** daß
sich bei den U-förmigen Leseverstärker-Transistoren (6) Drain (D) zwischen den Schenkeln des "U" und Source (S) außerhalb der Schenkel des "U" befinden.
